# EUROPEAN PATENT APPLICATION

(11) **EP 4 560 632 A1**
(43) Date of publication of application: **28.05.2025**
(21) Application number: 24214191.9
(22) Date of filing: 20.11.2024
(51) Int. Cl.: G11C 7/10, G11C 13/00

(54) **EXCLUSIVE-OR BASED NON-VOLATILE MEMORY**

(30) Priority: 21.11.2023 KR 20230162483; 03.01.2024 KR 20240000869; 04.04.2024 KR 20240046037
(71) Applicant: Samsung Electronics Co., Ltd., Suwon-si, Gyeonggi-do 16677 (KR)
(72) Inventor: Lee, Jaehyuk, 16678 Suwon-si, Gyeonggi-do (KR); Kwon, Soon-Wan, 16678 Suwon-si, Gyeonggi-do (KR); Kim, Sang Joon, 16678 Suwon-si, Gyeonggi-do (KR); Myung, Sungmeen, 16678 Suwon-si, Gyeonggi-do (KR); Seo, Boyoung, 16678 Suwon-si, Gyeonggi-do (KR); Yun, Seok Ju, 16678 Suwon-si, Gyeonggi-do (KR); Lee, Kangho, 16678 Suwon-si, Gyeonggi-do (KR)
(74) Representative: Grünecker Patent- und Rechtsanwälte PartG mbB

(57) **Abstract**

A non-volatile memory device includes a memory array including N+1 resistive memory cells expressing a bit sequence of N bits for each word line, in which N is an integer greater than or equal to 2.

## Description

### BACKGROUND

### 1. Field

The following description relates to a non-volatile memory device providing memory read and write operations based on exclusive OR.

### 2. Description of Related Art

Semiconductor memory devices may be classified into volatile memory devices and non-volatile memory devices. When the power supply is interrupted, volatile memory devices lose stored data and non-volatile memory devices do not. Volatile memory devices have relatively high read and write speeds but lose stored content when the external power supply is cut off. On the other hand, the non-volatile memory devices have relatively low read and write speeds compared to the volatile memory devices but retain stored content external power is interrupted.

### SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

The invention is what is claimed in the independent claims. Preferred embodiments are specified by the dependent claims.

In one general aspect, a non-volatile memory device includes a memory array including N+1 resistive memory cells expressing a bit sequence of N bits for each word line, in which N is an integer greater than or equal to 2.

When a bit value of a bit position in the bit sequence is a first bit value, resistance values of adjacent memory elements corresponding to the bit position among the N+1 resistive memory cells are the same, and, when the bit value of the bit position is a second bit value, resistance values of adjacent memory elements corresponding to the bit position among the N+1 resistive memory cells are different.

The memory device may further include a write encoder configured to generate N+1 write signals individually indicating resistance values to be set for the N+1 resistive memory cells, based on a reference signal and N bit signals individually indicating bit values of the bit sequence.

The write encoder may include a plurality of exclusive-OR (XOR) elements, in which an output of at least one XOR element of the plurality of XOR elements is connected to an input of another XOR element.

The write encoder may generate the N+1 write signals including outputs of the plurality of XOR elements and the reference signal.

The write encoder may include a first XOR element configured to receive a bit signal corresponding to a most significant bit (MSB) and the reference signal and generate a first XOR result between a bit value of the MSB and a bit value of the reference signal and a second XOR element configured to receive a subsequent bit signal of the MSB and the first XOR result and generate a second XOR result between a bit value of the subsequent bit signal and the first XOR result.

The memory device may set resistance values according to a result of encoding the bit sequence based on XOR for resistive memory cells arranged along a word line selected for writing.

The memory device may set one resistance value combination among available resistance value combinations expressing the bit sequence for the N+1 resistive memory cells of a word line selected for writing.

The memory device may select a resistance value combination, of which a predicted power consumption for writing is low, from among the available resistance value combinations.

The memory device may select a resistance value combination, of which the number of resistance changes required for the N+1 resistive memory cells is small, from among the available resistance value combinations, based on the resistance values set for the N+1 resistive memory cells of the word line selected for writing.

The memory device may change a resistance value of a resistive memory cell including a different resistance value from the resistance value combination selected from among the N+1 resistive memory cells of the word line selected for writing and may maintain a resistance value of a resistive memory cell including the same resistance value as the resistance value combination selected from among the N+1 resistive memory cells of the word line selected for writing.

The memory device may further include a readout circuit configured to generate bit read signals based on XOR results for resistance values set for the N+1 resistive memory cells arranged along a word line selected for reading.

The readout circuit may include an XOR element connected to two adjacent resistive memory cells among the N+1 resistive memory cells.

The readout circuit may output, as a bit value for the two adjacent resistive memory cells, a comparison result between delays occurring in the two adjacent resistive memory cells, according to a parasitic capacitance and resistance values set for the two adjacent resistive memory cells.

In another general aspect, an operating method of a non-volatile memory device includes setting resistance values expressing a bit sequence of N bits for N+1 resistive memory cells arranged in a word line selected for writing in a memory array and outputting N bit read signals from N+1 resistive memory cells arranged in a word line selected for reading in the memory array, in which N is an integer greater than or equal to 2.

The setting of the resistance values may include, when a bit value of a bit position in the bit sequence is a first bit value, setting the same resistance value for adjacent memory elements corresponding to the bit position and, when the bit value of the bit position is a second bit value, setting different resistance values for adjacent memory elements corresponding to the bit position.

The setting of the resistance values may include, through a write encoder, generating N+1 write signals individually indicating resistance values to be set for the N+1 resistive memory cells, based on a reference signal and N bit signals individually indicating bit values of the bit sequence and, through a write driver, setting resistance values of the N+1 resistance memory cells to the N+1 write signals.

The setting of the resistance values may include writing one resistance value combination among available resistance value combinations expressing the bit sequence in the N+1 resistive memory cells of a word line selected for writing.

The setting of the resistance values may further include selecting a resistance value combination, of which a predicted power consumption for writing is low, from among the available resistance value combinations.

The outputting may include generating the N bit read signals based on XOR results for resistance values set for the N+1 resistive memory cells arranged along a word line selected for reading.

In another general aspect, a method of encoding a bit value by using two resistive memory cells that are adjacent to each other includes, when the bit value is a first value, setting the same resistance value for the two resistive memory cells and, when the bit value is a second value that is different from the first value, setting different resistance values for the two resistive memory cells.

The encoding may be an XOR, in which the first value is 0 and the second value is 1.

The encoding may be an exclusive negative OR (XNOR), in which the first value is 1 and the second value is 0.

N bit values may be encoded by using N+1 resistive memory cells.

The N+1 resistive memory cells may be connected to a shared word line in which N is an integer greater than or equal to 2.

Other features and aspects will be apparent from the following detailed description, the drawings, and the claims.

### BRIEF DESCRIPTION OF THE DRAWINGS

FIG. 1 illustrates an example memory array of a memory device, according to one or more embodiments.
FIG. 2 illustrates an example configuration of the memory device, according to one or more embodiments.
FIG. 3 illustrates one or more operating method of the memory device, according to one or more embodiments.
FIG. 4 illustrates a read operation of the memory device, according to one or more embodiments.
FIG. 5 illustrates an example of a bit sequence using a resistance value combination in the memory device, according to one or more embodiments.
FIGS. 6, 7A, and 7B illustrate a read operation through a readout circuit in the memory device, according to one or more embodiments.
FIGS. 8, 9A, and 9B illustrate a write operation through a write circuit in the memory device, according to one or more embodiments.

Throughout the drawings and the detailed description, unless otherwise described or provided, the same or like drawing reference numerals will be understood to refer to the same or like elements, features, and structures. The drawings may not be to scale, and the relative size, proportions, and depiction of elements in the drawings may be exaggerated for clarity, illustration, and convenience.

### DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences of operations described herein are merely examples, and are not limited to those set forth herein, but may be changed as will be apparent after an understanding of the disclosure of this application, with the exception of operations necessarily occurring in a certain order. Also, descriptions of features that are known after an understanding of the disclosure of this application may be omitted for increased clarity and conciseness.

The features described herein may be embodied in different forms and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

The terminology used herein is for describing various examples only and is not to be used to limit the disclosure. The articles "a," "an," and "the" are intended to include the plural forms as well, unless the context clearly indicates otherwise. As used herein, the term "and/or" includes any one and any combination of any two or more of the associated listed items. As non-limiting examples, terms "comprise" or "comprises," "include" or "includes," and "have" or "has" specify the presence of stated features, numbers, operations, members, elements, and/or combinations thereof, but do not preclude the presence or addition of one or more other features, numbers, operations, members, elements, and/or combinations thereof.

Throughout the specification, when a component or element is described as being "connected to," "coupled to," or "joined to" another component or element, it may be directly "connected to," "coupled to," or "joined to" the other component or element, or there may reasonably be one or more other components or elements intervening therebetween. When a component or element is described as being "directly connected to," "directly coupled to," or "directly joined to" another component or element, there can be no other elements intervening therebetween. Likewise, expressions, for example, "between" and "immediately between" and "adjacent to" and "immediately adjacent to" may also be construed as described in the foregoing.

Although terms such as "first," "second," and "third", or A, B, (a), (b), and the like may be used herein to describe various members, components, regions, layers, or sections, these members, components, regions, layers, or sections are not to be limited by these terms. Each of these terminologies is not used to define an essence, order, or sequence of corresponding members, components, regions, layers, or sections, for example, but used merely to distinguish the corresponding members, components, regions, layers, or sections from other members, components, regions, layers, or sections. Thus, a first member, component, region, layer, or section referred to in the examples described herein may also be referred to as a second member, component, region, layer, or section without departing from the teachings of the examples.

Unless otherwise defined, all terms, including technical and scientific terms, used herein have the same meaning as commonly understood by one of ordinary skill in the art to which this disclosure pertains and based on an understanding of the disclosure of the present application. Terms, such as those defined in commonly used dictionaries, are to be interpreted as having a meaning that is consistent with their meaning in the context of the relevant art and the disclosure of the present application and are not to be interpreted in an idealized or overly formal sense unless expressly so defined herein. The use of the term "may" herein with respect to an example or embodiment, e.g., as to what an example or embodiment may include or implement, means that at least one example or embodiment exists where such a feature is included or implemented, while all examples are not limited thereto.

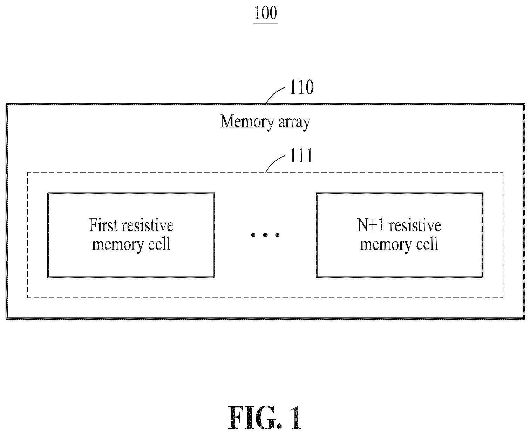

FIG. 1 illustrates an example memory array of a memory device 100, according to one or more embodiments.

The non-volatile memory device 100 (or the memory device 100) may include a memory array 110. Herein, electronic devices, such as non-volatile memory device 100, are representative of one or more processors, or one or more processors and a memory storing instructions, configured to implement one or more, or any combination of, operations or methods described herein. The one or more processors may be respective special purpose hardware-based computers or other special-purpose hardware. The one or more processors may be configured to execute such instructions. The one or more memories may store the instructions, which when executed by the one or more processors configure the one or more processors to perform one or more, or any combination of operations of methods described herein.

The memory array 110 may include resistive memory cells. The resistive memory cells may be arranged along lines. For example, the resistive memory cells may be arranged along word lines and column lines. A word line may also be referred to as a row line.

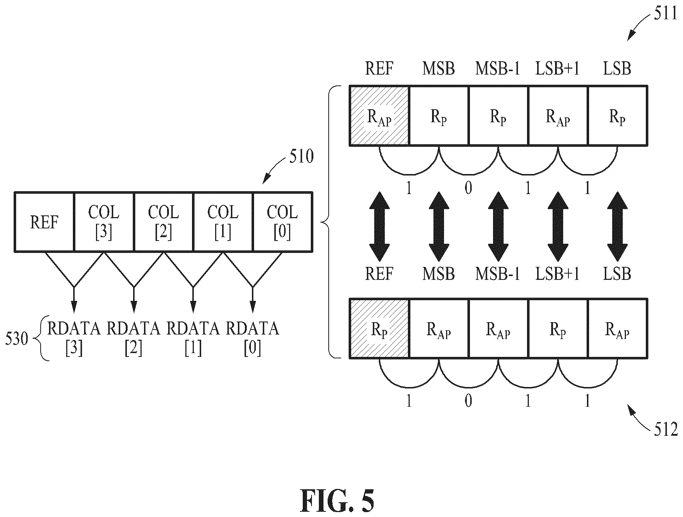

The memory array 110 may have N+1 resistive memory cells 111 for expressing a bit sequence of N bits for each word line. N may be greater than or equal to 2. The bit sequence may be a sequence of bit values. The bit sequence including N bit values ("N-bit sequence") is mainly described herein. A combination of N+1 resistance values (e.g., high/low) individually set for the N+1 resistive memory cells 111, corresponding to any one of the word lines, may correspond to (express/represent) an N-bit sequence. First to N+1-th resistive memory cells, as shown in FIG. 1, may be arranged along the same word line. The N+1 resistance values, to represent the desired N-bit sequence, may be determined based on a result of encoding the N-bit sequence. Encoding may be based on, for example, an exclusive OR (XOR) scheme. For example, a bit value may depend on the XOR of the values of two cells (e.g., if they are the same, '1', and otherwise '0'). A mapping relationship between a resistance value combination (e.g., the values in the N+1 cells) and a bit sequence (e.g., the N-bit sequence) is described below with reference to FIG. 5. The resistance value combination may be a combination of resistance values individually set for the respective N+1 resistive memory cells 111 of a word line corresponding to the resistance value combination; a resistance value combination may also be referred to as a resistance value sequence.

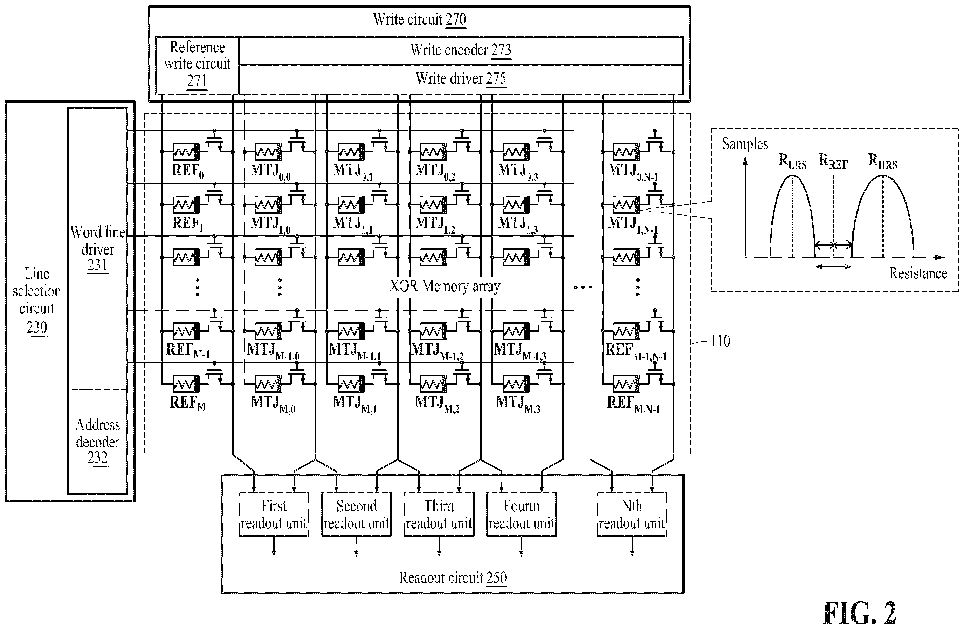

A resistive memory cell may include a resistive memory element. The resistive memory element (e.g., a magnetic tunnel junction (MTJ)) may be an element that has a set resistance value and may have one of multiple resistance values. The resistive memory element may have a resistance value of, for example, a first resistance value or a second resistance value. The first resistance value may be less than the second resistance value. The first resistance value may be a resistance value (e.g., R_{P}, in the MTJ example, referring to resistance-parallel) in a low resistance state (LRS), and the second resistance value may be a resistance value (e.g., R_{AP}, in the MTJ example, resistance-anti-parallel) in a high resistance state (HRS). As described below with reference to FIG. 2, the resistive memory element of the resistive memory cell may be, for example, magnetic random-access memory (MRAM).

According to an embodiment, resistance states (e.g., resistance values) of multiple resistive memory elements may configured/used to represent a single bit value. For example, a single bit value may be determined according to two resistance values of two adjacent resistive memory elements. For example, two adjacent same resistance-states may represent a first bit value (e.g., a bit value of 0), and two adjacent different resistance-states may represent a second bit value (e.g., a bit value of 1). For example, when a bit value of a specific bit position in a bit sequence is the first bit value, resistance values of adjacent memory elements corresponding to the specific bit position (among the N+1 resistive memory cells 111) may be the same. When a bit value of a specific bit position is the second bit value, resistance values of adjacent memory elements corresponding to the specific bit position (among the N+1 resistive memory cells 111) may be different.

An operating method (e.g., a memory encoding method) of the memory device 100 may involve encoding a bit value by using two adjacent resistive memory cells, i.e., mapping the bit value to appropriate resistance values of the adjacent resistive memory cells such that they can later be decoded to retrieve (reconstruct) the bit value therefrom. For example, the memory encoding method may set resistance values of two adjacent resistive memory cells to be the same when the bit value is a first value. The memory encoding method may set resistance values of two adjacent resistive memory cells to be different when the bit value is a second value. In the memory encoding method, N bit values may be encoded to resistance values of N+1 resistive memory cells that will store the N bit values (and the N+1 resistive memory cells' respective resistances set accordingly). The N+1 resistive memory cells may be connected to a shared word line (N may be greater than or equal to 2).

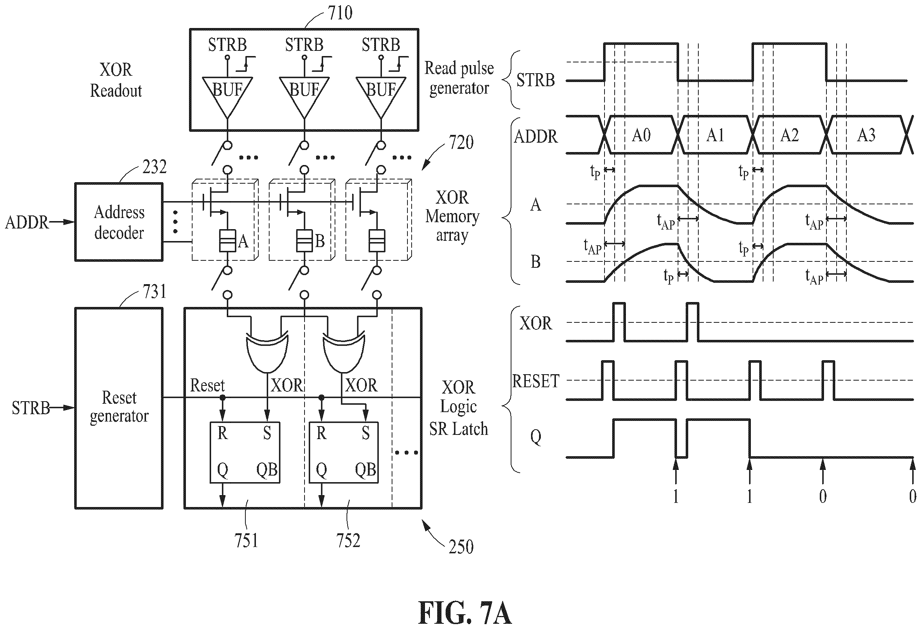

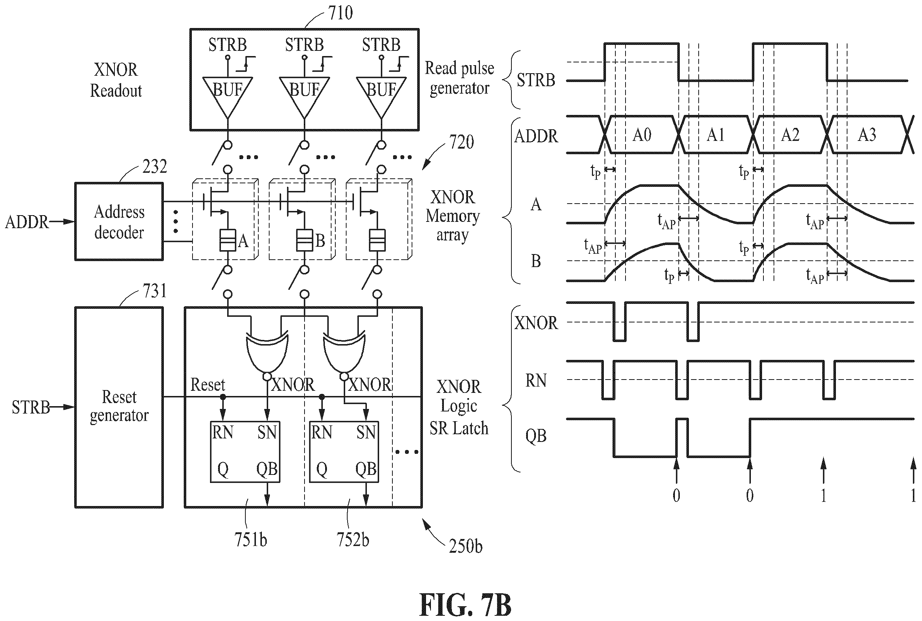

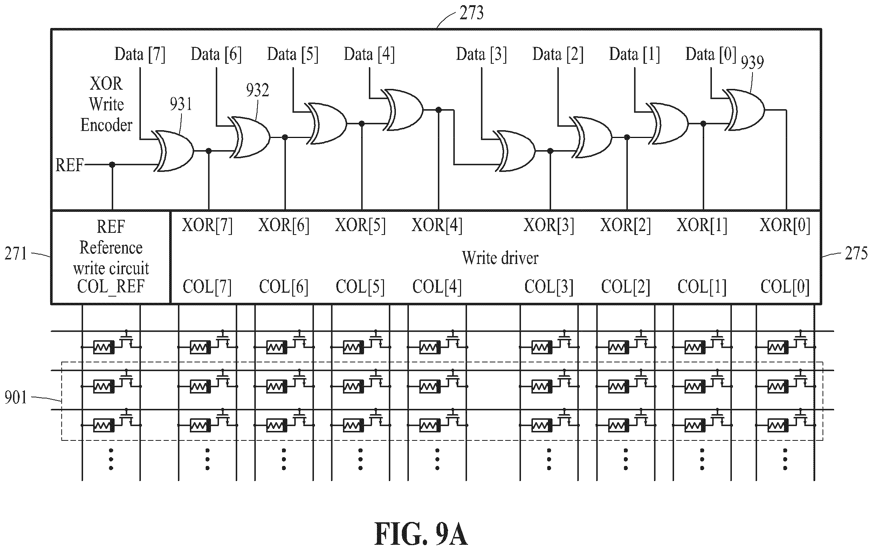

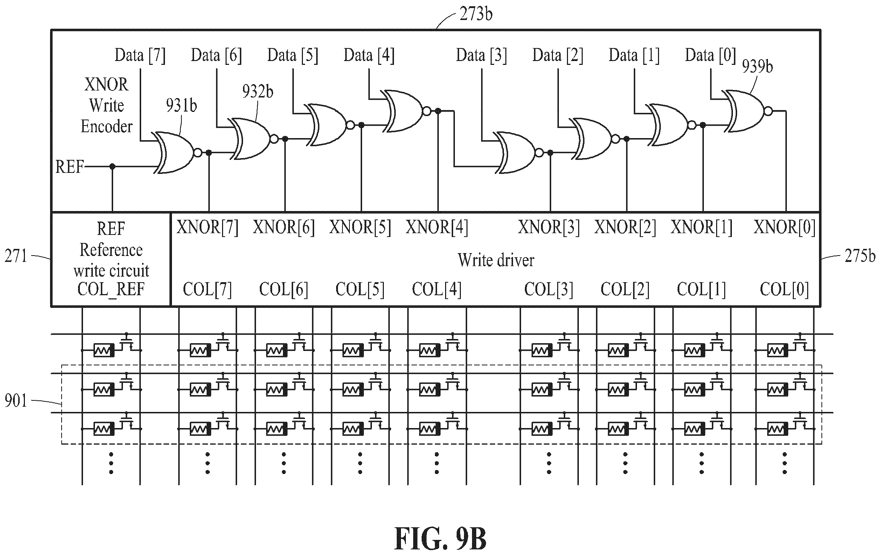

For reference, a non-limiting example where the first bit value is 0 and the second bit value is 1 is mainly described herein. The memory encoding method may be based on XOR, in which the first value is 0 and the second value is 1. Encoding that maps the bit value of 0 to two equal resistance values and maps the bit value of 1 to two differing resistance values, of two resistive memory elements, may be referred to as XOR encoding (here, "same" is functional - differences within a tolerance are expected). As described below, resistance values set through such mapping may be converted into bit values through XOR decoding operations. However, examples are not limited thereto. The memory encoding method may instead be based on exclusive negative OR (XNOR), in which the first value is 1 and the second value is 0. This may be referred to as XNOR encoding. XOR encoding-related operations are described below with reference to FIGS. 7A and 9A, and XNOR encoding-related operations are described below with reference to FIGS. 7B and 9B.

The memory device 100, in some embodiments, may have a memory macro structure having resistive memory cells to which set to resistance values obtained by encoding a bit sequence based on XOR encoding. The memory macro structure of the memory device 100 may have a decreased area overhead and an increased readout margin relative to prior resistive memory devices. Accordingly, the memory device 100 may use less power than prior devices to perform a read process.

FIG. 2 illustrates an example configuration of the memory device 100, according to one or more embodiments.

The memory device 100 may include the memory array 110, a line selection circuit 230, a readout circuit 250, and a write circuit 270.

As described above, the memory array 110 may include N+1 resistive memory cells for expressing/representing an N-bit sequence for each line (e.g., word line). In the example illustrated in FIG. 2, the memory array 110 may have M+1 word lines and N+1 column lines. The N+1 column lines may include N data column lines and one reference column line (left side). Here, M may be greater than or equal to 1, and N may be greater than or equal to 2. The memory array 110 may include a total of (M+1)×(N+1) resistive memory cells.

In the example illustrated in FIG. 2, a resistive memory cell may have 1T 1R (e.g., a one transistor/one resistor) structure, i.e., one transistor and one resistive element. A cell's one transistor may operate as a switching element that to control access to the cell's corresponding resistive element (among the resistive elements arranged along lines). The switching element (e.g., the transistor) of the resistive memory cell may be turned on by a word line driver 231 as described below. Referring to FIG. 2, the resistive memory cell may include an MRAM element as a resistive memory element.

The MRAM element may have, for example, a magnetic tunnel junction (MTJ) element. Referring to FIG. 2, MTJ_{i,j} is the MTJ element of the i-th word line (among word lines) and of the j-th data column line (among data column lines). REFᵢ is an MTJ element of the i-th word line and of a reference line (e.g., the reference column line). i may be greater than or equal to 0 and less than or equal to M, and j may be greater than or equal to 0 and less than or equal to N-1.

An MTJ element may be a memory element whose resistance value changes depending on the spin state of internal electrons. For example, the MRAM element may have a resistance value corresponding to either of an HRS R_{AP} and an LRS R_{P}, depending on the setting/implementation. The MRAM element may be non-volatile due to preservation of the spin state of the internal electrons even when the power voltage is removed. The size and leakage current of the MRAM element may be small. The MRAM element is mainly described as an example of a resistive memory element herein, but examples are not limited thereto. The resistive memory element may be, for example, a ferroelectric RAM (FRAM) element, a phase change memory (PCM) element, a 3D XPoint element, a spin-transfer torque (STT)-MRAM element, a nano-RAM (NRAM) element, a resistive RAM (ReRAM) element, a conductive bridge RAM (CBRAM), or any other suitable to of resistive memory element.

The line selection circuit 230 may select at least one word line, from among the multiple word lines, for a read operation or a write operation. The line selection circuit 230 may include an address decoder 232 and the word line driver 231.

The address decoder 232 may identify, from among the word lines, a word line corresponding to a given address. For example, a memory device may receive an access request for a memory (e.g., the memory array 110) from an external device (e.g., a host). The access request may be a request for access for a read operation or a write operation and may include information (e.g., a memory address) indicating a memory position intended to be accessed in the memory (e.g., the memory array 110). By decoding the memory address, the address decoder 232 may generate information indicating a word line corresponding to the requested memory position from among the word lines.

The word line driver 231 may activate a word line corresponding to the access request. For example, the word line driver 231 may enable a signal (e.g., a word line selection signal) to a word line selected from among the word lines. The word line driver 231 may enable an activation signal to a word line indicated by a result of the address decoder 232 decoding the access request. Switching elements (e.g., transistors) of respective resistive memory cells connected to the selected word line may be turned on by the signal enabled to the selected word line. Resistive memory elements arranged on the selected word line may be individually connected to respective column lines. The memory device may set (e.g., write) a resistance value for the resistive memory elements of the activated word line or may read a previously stored resistance value. One resistive element may store data.

The readout circuit 250 may read data (e.g., the N-bit sequence) recorded in the N+1 resistive memory cells of the memory array 110. For example, the readout circuit 250 may generate a bit-read signal based on the result of XORs between resistance values set for the N+1 resistive memory cells arranged along a word line selected for reading. As described below with reference to FIG. 5, resistance value combinations (e.g., of N+1 values) may be mapped to bit sequences (e.g. N-bit sequences) based on XOR encoding. The readout circuit 250 may include N readout units (e.g., a first readout unit to an N-th readout unit) of the respective columns that are configured to individually generate N respective bit-read signals. Since each readout unit includes its own logic element and/or a logic circuit (e.g., an XOR circuit), a readout unit may have a relatively simplified structure and reduced power consumption. In addition, since a comparison (e.g., XOR) between resistive memory cells along adjacent column lines is performed, a readout margin may be secured, and a further efficient read operation may be enabled.

The write circuit 270 may write resistance values (values according to a corresponding N-bit sequence) to resistive memory cells of the memory array 110. If a memory access request is a request for writing, the memory access request may include a memory address and a value (e.g., a bit sequence) to be recorded in the memory address. For resistive memory cells of a word line activated for the memory access request, the write circuit 270 may set resistance values corresponding to a result of an XOR encoding of the bit sequence of the memory access request. The write circuit 270 may include a reference write circuit 271, a write encoder 273, and a write driver 275.

The reference write circuit 271 may set resistance values of resistive memory elements arranged along the reference column line. For example, the reference write circuit 271 may set a resistance value determined according to XOR encoding for a resistive memory element corresponding to the reference column line in a selected word line. As described below, the reference resistance value of a word line may indicate how XOR decoding is to be performed for the resistive memory elements of that word line.

Although FIG. 2 illustrates the reference write circuit 271 separately from the write encoder 273 and the write driver 275, examples are not limited thereto. The configuration and/or function of the reference write circuit 271 may be integrated into the write encoder 273 and/or the write driver 275. The division of functionality between components is arbitrary and not significant.

The write encoder 273 may generate N+1 write signals individually indicating resistance values to be set for the N+1 resistive memory cells of the selected row/word line, which may be based on a reference signal and N bit signals (the data to be stored) individually indicating bit values of the N-bit sequence. The reference signal may be a signal that indicates a bit value corresponding to a resistance value (e.g., a reference resistance value) that is set for a resistive memory element arranged in the reference column line in the corresponding word line. The N bit signals may be signals that individually indicate bit values corresponding to bit positions of the N-bit sequence. Each of the N+1 write signals may indicate a resistance value set for a corresponding resistive memory cell in the word line.

To summarize, the write driver 275 may translate the binary N+1 write signals into respectively corresponding voltages/currents to be written. More specifically, the write driver 275 may set resistance values, which are to be written to resistive memory cells on a word line selected for writing, according to a result of XOR-encoding of the to-be-written bit sequence. Each of the N+1 write signals may indicate a resistance value to be set for a respectively corresponding resistive memory element of a specific position among the N+1 resistive memory elements in the selected word line. The write driver 275 may set a resistance value indicated by a specific write signal for a corresponding resistive memory cell. The write driver 275 may set resistance values of the N+1 resistance memory cells by using the N+1 write signals. For example, if a bit value of the specific write signal is 0, the write driver 275 may set a resistance value (e.g., R_{P}) of a first resistance state (e.g., the LRS) for a corresponding resistive memory cell. For another example, if the bit value of the specific write signal is 1, the write driver 275 may set a resistance value (e.g., R_{AP}) of a second resistance state (e.g., the HRS) for a corresponding resistive memory cell. The write driver 275 may set a resistance value determined based on XOR encoding for a corresponding resistive memory element by enabling a set signal (e.g., a voltage and/or a current) corresponding to a corresponding write signal to each resistive memory element of the activated word line.

According to some embodiments, in the memory device, two resistance values set for two respective adjacent (in the row direction) resistive memory cells arranged along a word line together express/represent one bit value. The memory device may read a bit value resistive memory element regardless of its resistance offset corresponding to its position in the memory array 110 (e.g., caused by wiring resistance, which can vary among the resistive memory elements due to their varying circuit locations and corresponding wire lengths).

In some embodiments, a reference resistance used to read a resistance value of a specific resistive memory cell may be a resistance value of a resistive memory cell in the row of the specific resistive memory cell. As compared to other technologies, since a reference threshold resistance R_{REF} of a reference row or a reference column is compared to a resistance (e.g., R_{LRS} or R_{HRS}) of each resistive memory cell, there is a problem that the resistance of each resistive memory cell depends on its row position and/or its column position. On the other hand, some embodiments of the memory device described herein may avoid this problem since the resistance value of each resistive memory cell is compared to a resistance value of an adjacent (in the row direction, e.g., adjacent to the right) resistive memory cell, a read offset (location-dependent resistance component) may be suppressed even in different column positions.

The memory device may read bit values according to a combination of resistance values (i.e., according to the resistance values of each resistive memory element) by providing a further increased readout margin despite a variance of a resistance value of a resistive memory element (e.g., an MTJ). In comparing adjacent resistive memory elements, since the resistive memory elements are implemented with the same material, a process, voltage, and temperature (PVT) variance 211 moves in the same direction for each element, and a further robust read feature may be provided.

In addition, other technologies the LRS may be a state having a resistance lower than the reference resistance, and the HRS may be a state having a resistance higher than the reference resistance. On the contrary, in some embodiments described herein, the LRS may merely be a state lower than the HRS, and the HRS may be a state higher than the LRS. Accordingly, in the memory device according to some embodiments, a readout margin considered in order to identify a resistance state may substantially increase compared to prior technologies. For example, the readout margin may increase by about two times. This is because an adjacent MTJ element (in the row direction, e.g., to the right) having a symmetrical layout may function as a kind of reference. Accordingly, since the memory device secures a relatively large noise margin, the memory device may provide further robustness of readout results against PVT variance 211.

Two MTJs may be a reference for each other and may be implemented in a small area. As described above, the memory array 110 may be implemented through the N+1 resistive memory cells (e.g., the N+1 resistive memory elements) as the N-bit sequence. Accordingly, an area overhead for providing the aforementioned possible benefits is minute since only one column line is added in an entire macro structure.

Memory devices according to some embodiments may be non-volatile yet may effectively decrease power consumption and may block leakage current by retaining data even when power is off. The memory devices may be used in various hardware including a neuromorphic processor, a mobile device, or an edge device. The memory device may provide a decreased power consumption and a decreased area in a read operation and a write operation.

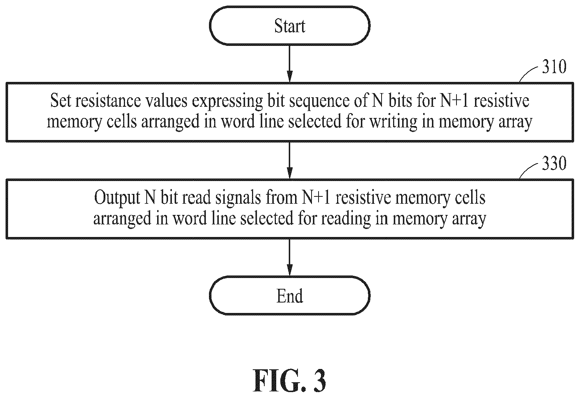

FIG. 3 illustrates an operating method of the memory device, according to one or more embodiments.

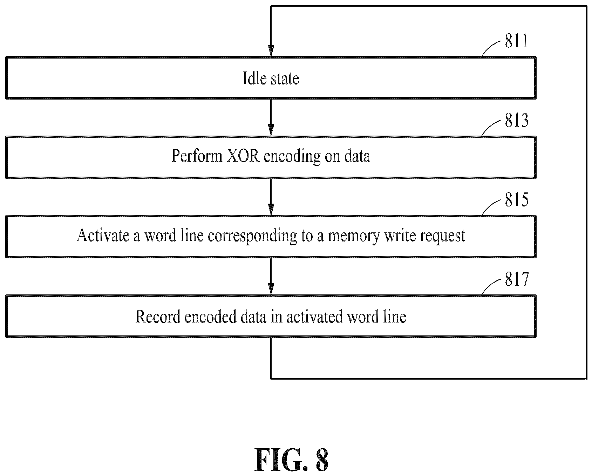

In operation 310, a non-volatile memory device may set resistance values for expressing an N-bit sequence for N+1 respective resistive memory cells arranged in a word line selected for writing in a memory array. Here, N may be greater than or equal to 2. For example, a word line driver of the memory device may select a word line corresponding to a memory write request. A write circuit may set resistance values determined based on XOR encoding from a bit sequence corresponding to the memory write request for resistive memory cells arranged along a selected word line. When a bit value of a bit position in the bit sequence is a first bit value, the memory device may set the same resistance value for adjacent memory element corresponding to the bit position. When the bit value of the bit position is a second bit value, the memory device may set a different resistance value for the adjacent memory element corresponding to the bit position. The write operation of the memory device is described below with reference to FIGS. 8, 9A, and 9B.

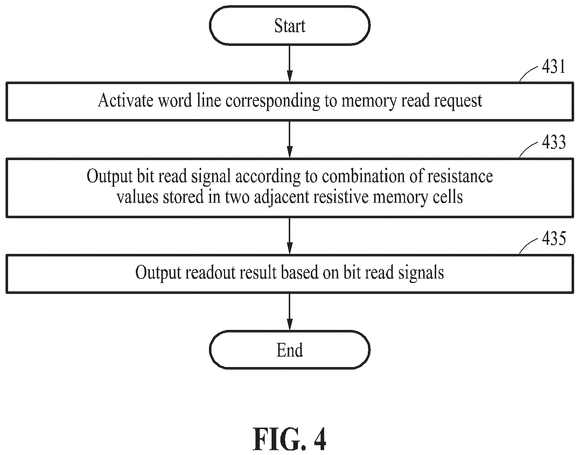

In operation 330, the non-volatile memory device may output N bit-read signals from N+1 resistive memory cells arranged in a word line selected for reading in the memory array. For example, the word line driver of the memory device may select a word line corresponding to a memory read request. A readout circuit may determine bit-read signals based on an XOR operation from resistance values set for resistive memory cells of a word line corresponding to the memory read request. The read operation of the memory device is described below with reference to FIGS. 4 to 7A and 7B.

FIG. 4 illustrates a read operation of the memory device, according to one or more embodiments. FIG. 5 illustrates an example of a bit sequence using a resistance value combination in the memory device, according to one or more embodiments.

In operation 431, the memory device, according to an embodiment, may activate a word line corresponding to a memory read request. For example, the memory device may identify a word line indicated by a memory address of the memory read request. The memory device may activate resistive memory cells by connecting resistive memory elements of the identified word line to corresponding column lines, respectively.

In operation 433, the memory device may output a bit-read signal according to a combination of resistance values stored in two adjacent (in the same row) resistive memory cells. The memory device may determine a bit-read signal indicating a bit value for each of the two adjacent resistive memory cells in resistive memory elements arranged along a word line. The memory device may determine a bit value corresponding to resistance values of the two adjacent resistive memory cells based on mapping according to XOR encoding. The mapping according to XOR encoding is described below through Tables 1 and 2. Table 1 is a truth table of an XOR element provided as a reference.

**Table 1**

| A | B | Q |
|---|---|---|
| 0 | 0 | 0 |
| 0 | 1 | 1 |
| 1 | 0 | 1 |
| 1 | 1 | 0 |

As shown in Table 1, in XOR, when inputs A and B are the same, an output Q is 0, and, when the inputs A and B are different, the output Q is 1. A resistance value (e.g., R_{P}) of a first resistance state (e.g., an LRS) itself or a signal (e.g., a voltage signal or a current signal) corresponding to the resistance value of the first resistance state may represent a first logic value (e.g., L or 0). A resistance value (e.g., R_{AP}) of a second resistance state (e.g., an HRS) itself or a signal (e.g., a voltage signal or a current signal) corresponding to the resistance value of the second resistance state may represent a second logic value (e.g., H or 1). Referring to the truth table as shown in Table 1, the inputs A and B for an XOR operation are logic values corresponding to resistance values set for adjacent resistive memory elements and the output Q may be a bit value. Accordingly, mapping between a combination of a resistance value and each bit value according to XOR encoding may be represented by Table 2 below.

**Table 2**

| Data Value | Resistance Value Combination Based on XOR Encoding or XOR Decoding |
|---|---|
| 0 | (R_{AP}, R_{AP}) or (R_{P}, R_{P}) |
| 1 | (R_{AP}, R_{P}) or (R_{P}, R_{AP}) |

As shown in Table 2 above, a bit value of 0 may be written and read as a state (R_{AP}, R_{AP}) or (R_{P}, R_{P}) in which resistance values of two resistive memory cells are the same. A bit value of 1 may be written and read as a state (R_{AP}, R_{P}) or (R_{P}, R_{AP}) in which resistance values of two resistive memory cells are different. An XOR operation result between logic values corresponding to resistance values stored in two resistive memory cells may be a bit value of a corresponding bit position. Accordingly, an XOR encoding result of the bit value may be resistance values stored in the two adjacent resistive memory cells corresponding to the bit position.

In operation 435, the memory device may output a readout result based on bit-read signals. As described above, resistive memory cells arranged along each word line of a memory array may have resistance values corresponding to a result of an XOR-based encoding of a bit sequence. According to some embodiments, the memory device may determine a bit sequence to be read-out by decoding a resistance value combination based on an XOR operation. For example, the memory device may generate the bit-read signals by collectively performing an operation according to operation 433 for each pair of adjacent resistive memory cells (in a word/row). For reference, there are N adjacent pairs when there are N+1 resistive memory cells, and an operation according to operation 433 may be simultaneously and/or parallelly performed on the N adjacent pairs. The memory device may generate, as a readout result, an N-bit sequence corresponding to the resistance value combination (e.g., a resistance value sequence) by combining (joining) bit values individually indicated by the generated bit-read signals.

To aid understanding XOR-based decoding of N+1 resistance values to N bit values, consider example 510 shown in FIG. 5. Example 510 involves expressing a 4-bit sequence 530 (4 data bits) through 4 data column lines COL[3:0] and a reference column line REF (5 resistance values). The 4-bit sequence 530 is denoted by RDATA[3:0], and the data of the 4-bit sequence 530 may be "1011", as an example. A first resistance value combination 511 (upper right) is a first way of expressing the example 4-bit sequence 530 ("1011"), and the second resistance value combination 512 (lower right) is a second way of expressing the same 4-bit sequence 530 ("1011").

In the case of the first resistance value combination 511, in the 4-bit sequence 530, if the reference resistance value (REF) is R_{AP}, 1, which is RDATA[3] (e.g., a most significant bit (MSB)), is expressed by (R_{AP}, R_{P}) (the XOR of REF and MSB). And, 0, which is RDATA[2] (e.g., MSB-1), is expressed by (R_{P}, R_{P}) (the XOR of MSB and MSB-1). Likewise, RDATA[1] and RDATA[0] are respectively expressed by (R_{P}, R_{AP}) (the XOR of MSB-1 and LSB+1) and (R_{AP}, R_{P}) (the XOR of LSB+1 and LSB). Accordingly, when combining these resistance values, the first resistance value combination 511 may be (R_{AP}, R_{P}, R_{P}, R_{AP}, R_{P}), whose the first resistance value is a reference resistance value having resistance value R_{AP}.

On the other hand, in the case of second resistance value combination 512, if the reference resistance value is R_{P}, a second resistance value combination 512 may be (R_{P}, R_{AP}, R_{AP}, R_{P}, R_{AP}). The reference resistance value may be a resistance value that is a reference for a resistance value combination (or a resistance value sequence) and may be, for example, the very first resistance value. The memory device may select a resistance value combination by determining a value of a write signal indicating the reference resistance value. For example, the memory device may select the first resistance value combination 511 by determining the value of the write signal indicating the reference resistance value to 1 (corresponding to R_{AP}). The memory device may select the second resistance value combination 512 by determining the value of the write signal indicating the reference resistance value to 0 (corresponding to R_{P}).

As described in the example above, according to XOR encoding, two resistance value combinations may always express a one bit sequence. For example, the memory device may set (e.g., write) one resistance value combination among available resistance value combinations expressing the bit sequence for the N+1 resistive memory cells of a word line selected for writing. As illustrated in FIG. 5, the resistance value combinations expressing one bit sequence may be in a complementary relationship due to XOR encoding. In other words, the resistance values of any one of the resistance value combinations may have a logic value opposite to the resistance values of the other resistance value combination in a corresponding column line. As described above, since two resistance value combinations correspond to the same bit sequence, the memory device may output the same bit sequence as a result of reading the two resistance value combinations.

FIG. 5 only illustrates the example of a single 4-bit bit sequence. Tables 3 and 4 show that two resistance value combinations are available for all 4-bit bit sequences. In Tables 3 and 4 below, COL[4] may be a reference column line, and COL[3:0] may be a data column line. Table 3 shows resistance value combinations individually corresponding to 4-bit bit sequences when a low resistance value R_{P} is set for a resistive memory cell of COL[4], that is the reference resistance value. Table 4 shows the resistance value combinations individually corresponding to 4-bit bit sequences when a high resistance value R_{AP} is set for the resistive memory cell of COL[4], that is the reference resistance value.

**Table 3**

| Original Data | | | | Resistance Value | | | | |
|---|---|---|---|---|---|---|---|---|
| DATA[3] | DATA[2] | DATA[1] | DATA[0] | COL[4] (REF) | COL[3] | COL[2] | COL[1] | COL[0] |
| 0 | 0 | 0 | 0 | R_{P} | R_{P} | R_{P} | R_{P} | R_{P} |
| 0 | 0 | 0 | 1 | R_{P} | R_{P} | R_{P} | R_{P} | R_{AP} |
| 0 | 0 | 1 | 0 | R_{P} | R_{P} | R_{P} | R_{AP} | R_{AP} |
| 0 | 0 | 1 | 1 | R_{P} | R_{P} | R_{P} | R_{AP} | R_{P} |
| 0 | 1 | 0 | 0 | R_{P} | R_{P} | R_{AP} | R_{AP} | R_{AP} |
| 0 | 1 | 0 | 1 | R_{P} | R_{P} | R_{AP} | R_{AP} | R_{P} |
| 0 | 1 | 0 | 1 | R_{P} | R_{P} | R_{AP} | R_{AP} | R_{P} |
| 0 | 1 | 1 | 0 | R_{P} | R_{P} | R_{AP} | R_{P} | R_{P} |
| 0 | 1 | 1 | 1 | R_{P} | R_{P} | R_{AP} | R_{P} | R_{AP} |
| 1 | 0 | 0 | 0 | R_{P} | R_{AP} | R_{AP} | R_{AP} | R_{AP} |
| 1 | 0 | 0 | 1 | R_{P} | R_{AP} | R_{AP} | R_{AP} | R_{P} |
| 1 | 0 | 1 | 0 | R_{P} | R_{AP} | R_{AP} | R_{P} | R_{P} |
| 1 | 0 | 1 | 1 | R_{P} | R_{AP} | R_{AP} | R_{P} | R_{AP} |
| 1 | 1 | 0 | 0 | R_{P} | R_{AP} | R_{P} | R_{P} | R_{P} |
| 1 | 1 | 0 | 1 | R_{P} | R_{AP} | R_{P} | R_{P} | R_{AP} |
| 1 | 1 | 1 | 0 | R_{P} | R_{AP} | R_{P} | R_{AP} | R_{AP} |
| 1 | 1 | 1 | 1 | R_{P} | R_{AP} | R_{P} | R_{AP} | R_{P} |

**Table 4**

| Original Data | | | | Resistance Value | | | | |
|---|---|---|---|---|---|---|---|---|
| DATA[3] | DATA[2] | DATA[1] | DATA[0] | COL[4] | COL[3] | COL[2] | COL[1] | COL[0] |
| 0 | 0 | 0 | 0 | R_{AP} | R_{AP} | R_{AP} | R_{AP} | R_{AP} |
| 0 | 0 | 0 | 1 | R_{AP} | R_{AP} | R_{AP} | R_{AP} | R_{P} |
| 0 | 0 | 1 | 0 | R_{AP} | R_{AP} | R_{AP} | R_{P} | R_{P} |
| 0 | 0 | 1 | 1 | R_{AP} | R_{AP} | R_{AP} | R_{P} | R_{AP} |
| 0 | 1 | 0 | 0 | R_{AP} | R_{AP} | R_{P} | R_{P} | R_{P} |
| 0 | 1 | 0 | 1 | R_{AP} | R_{AP} | R_{P} | R_{P} | R_{AP} |
| 0 | 1 | 0 | 1 | R_{AP} | R_{AP} | R_{P} | R_{P} | R_{AP} |
| 0 | 1 | 1 | 0 | R_{AP} | R_{AP} | R_{P} | R_{AP} | R_{AP} |
| 0 | 1 | 1 | 1 | R_{AP} | R_{AP} | R_{P} | R_{AP} | R_{P} |
| 1 | 0 | 0 | 0 | R_{AP} | R_{P} | R_{P} | R_{P} | R_{P} |
| 1 | 0 | 0 | 1 | R_{AP} | R_{P} | R_{P} | R_{P} | R_{AP} |
| 1 | 0 | 1 | 0 | R_{AP} | R_{P} | R_{P} | R_{AP} | R_{AP} |
| 1 | 0 | 1 | 1 | R_{AP} | R_{P} | R_{P} | R_{AP} | R_{P} |
| 1 | 1 | 0 | 0 | R_{AP} | R_{P} | R_{AP} | R_{AP} | R_{AP} |
| 1 | 1 | 0 | 1 | R_{AP} | R_{P} | R_{AP} | R_{AP} | R_{P} |
| 1 | 1 | 1 | 0 | R_{AP} | R_{P} | R_{AP} | R_{P} | R_{P} |
| 1 | 1 | 1 | 1 | R_{AP} | R_{P} | R_{AP} | R_{P} | R_{AP} |

The description of a 4-bit bit sequence is provided above, but two resistance value combinations are also available for an arbitrary N- bit sequence greater than or equal to 4 bits.

Table 5 below shows resistance value combinations to which 8b-bit bit sequence 8'b10010101 is mapped.

**Table 5**

| Bit Sequence | 8'b10010101 |
|---|---|
| 1 REF + 8 MTJ is used | R_{P}R_{AP}R_{AP}R_{AP}R_{P}R_{P}R_{AP}R_{AP}R_{P} or R_{AP}R_{P}R_{P}R_{P}R_{AP}R_{AP}R_{P}R_{P}R_{AP} |

Accordingly, even if a bit number N constituting a bit sequence increases, the memory device may express N bits (e.g., 8 bits) through N+1 (e.g., 9) resistive memory elements.

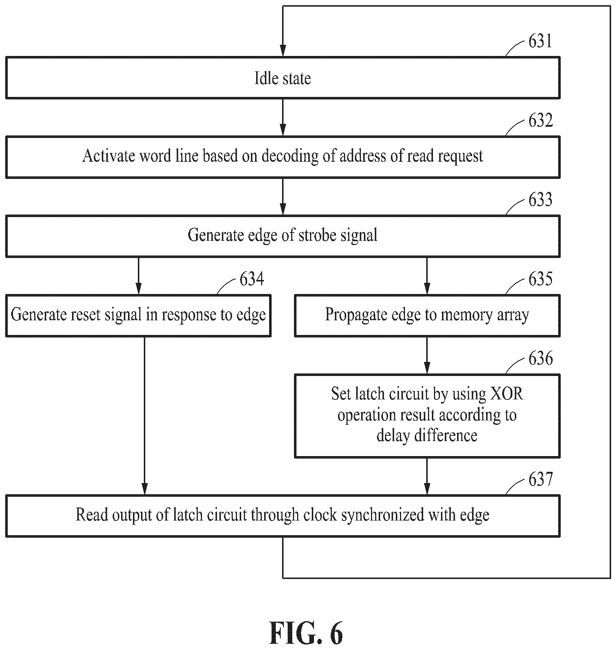

FIGS. 6, 7A, and 7B illustrate a read operation through a readout circuit in the memory device, according to one or more embodiments.

In operation 631, the memory device may wait for a memory access request in an idle state. The memory device may initiate an operation for memory reading in response to receiving a memory read request.

In operation 632, the memory device may activate a word line 720 based on the decoding of an address of a read request. For example, referring to FIG. 7A, the address decoder 232 may receive an address ADDR of the memory read request. The address decoder 232 may provide information indicating the word line 720 corresponding to a result of decoding the address ADDR. For example, a word line driver may activate the word line 720 corresponding to the address ADDR. By enabling a signal of 1 according to the word line 720 selected in a memory array, the word line driver may allow the transmission of a read pulse to resistive memory elements positioned in the selected word line 720.

In operation 633, the memory device may generate an edge of a strobe signal STRB. For example, a strobe signal generation circuit (not shown) of the memory device may generate the strobe signal STRB. The strobe signal STRB may be provided to a read pulse generator 710 and a reset generator 731 illustrated in FIG. 7A. Both a rising edge and a falling edge of the strobe signal STRB may be used.

In operation 634, the memory device may generate a reset signal in response to the edge. For example, the reset generator 731 may generate the reset signal in response to the strobe signal STRB. The reset generator 731 may detect both the rising edge and the falling edge of the strobe signal STRB. The reset generator 731 may transmit a pulse (e.g., a short pulse) to a reset port of SR latches of the readout circuit 250 at every rising edge and every falling edge of the strobe signal STRB. Accordingly, data stored in a node Q of an SR latch may be initialized to 0 at every edge of the strobe signal STRB.

In operation 635, the memory device may propagate the edge to the memory array. Referring to FIG. 7A, the read pulse generator 710 of the memory device may include a buffer connected to every column line (e.g., a bit line) and may drive the bit line by supplying the strobe signal STRB to a corresponding column line through the buffer.

In operation 636, the memory device may set a latch circuit using an XOR operation result according to a delay difference. According to an embodiment, the readout circuit 250 may include XOR elements connected to respective pairs of adjacent resistive memory cells among N+1 resistive memory cells. FIG. 7A illustrates an example that a first readout unit 751 and a second readout unit 752 individually include an XOR element. In the first readout unit 751, an XOR element may output a comparison result between a resistance value of a first resistive memory element A and a resistance value of an adjacent second resistive memory element B. For example, the first readout unit 751 may output 0 when the resistance value of the first resistive memory element A and the resistance value of the second resistive memory element B are the same and may output 1 when different.

In the example illustrated in FIG. 7A, a voltage may be provided to an inputter of an XOR element by power driven to the bit line. The time during which the voltage is charged or discharged may vary depending on a parasitic capacitance formed along the bit line and a resistance value set for a resistive memory cell. The XOR element may output a comparison result (e.g., 0 when two resistive memory elements are the same, and 1 when different) of resistance values set for two resistive memory elements through a delay (e.g., a charge delay or a discharge delay) varying depending on a resistance value set for each resistive memory element. For example, the readout circuit 250 may output, as a bit value for two adjacent resistive memory cells, a comparison result between delays occurring in the two adjacent resistive memory cells, according to a parasitic capacitance and resistance values set for the two adjacent resistive memory cells. Each XOR circuit of the readout circuit 250 may output an XOR output as "1" when a delay difference exceeds a threshold and may output the XOR output as "0" when the delay difference is less than or equal to the threshold.

For example, the first resistive memory element A and the second resistive memory element B of a first address A0 among a plurality of word lines may be R_{P} and R_{AP}, respectively. It may take a first time t_{P} until a voltage of a node connected to the XOR element and the first resistive memory element A for which the first resistance value R_{P} is set reaches a threshold voltage. It may take a second time t_{AP} until a voltage of a node connected to the XOR element and the second resistive memory element B for which the second resistance value R_{AP} is set reaches the threshold voltage. The first time t_{P} may be less than the second time t_{AP}. Accordingly, until the voltages of the first and second resistive memory elements A and B reach the threshold voltage, delays may occur for the first and second times t_{P} and t_{AP}, respectively, from the rising edge of the strobe signal STRB. Accordingly, the voltages of two inputters of the XOR element may differ for a delay difference t_{AP}-t_{P}. The XOR element may generate an output pulse corresponding to "1" (or a logic value H) during the delay difference t_{AP}-t_{P} This output pulse may be transmitted to a set port of an SR latch in a corresponding readout unit. A Node Q of the SR latch may output a signal corresponding to "1" (or the logic value H).

For another example, the first resistive memory element A and the second resistive memory element B of a second address A1 among the plurality of word lines may be R_{AP} and R_{P}, respectively. Likewise, until the voltages of the first and second resistive memory elements A and B reach the threshold voltage, delays may occur for the first and second times t_{AP} and t_{P}, respectively, from the falling edge of the strobe signal STRB. For reference, the rising edge may be a voltage charging time and the falling edge may be a voltage discharging time. The XOR element may generate an output pulse corresponding to the logic value H during the delay difference t_{AP}-t_{P.} The Node Q of the SR latch may output a signal corresponding to "1" (or the logic value H).

In yet another example, the first resistive memory element A and the second resistive memory element B of a third address A2 may be R_{P} and R_{P}, respectively. In this case, until the voltage of each resistive memory element reaches the threshold voltage, the same delay (e.g., t_{P}) may occur from an edge of the strobe signal STRB. Accordingly, the XOR element may provide a signal corresponding to "0" (or a logic value L). Accordingly, the SR latch may maintain a 0 value (e.g., the signal corresponding to the logic value L) initialized through the reset signal. Since the delay is the same as t_{AP} in a fourth address A3, the output of the SR latch may be maintained at 0.

For reference, although FIG. 7A only illustrates the example of the first resistive memory element A and the second resistive memory element B in the word line 720 corresponding to the first address A0, the same or similar description also applies to other of the N+1 resistive memory cells including a resistive memory element of a reference column line and resistive memory elements of a data column line.

In addition, since resistance values of resistive memory elements may not be ideally or perfectly the same, errors may occur. Accordingly, even when the same resistance value is set, a delay difference may occur. Accordingly, an XOR element (or an XOR circuit) may be designed to output a pulse signal corresponding to "1" (or the logic value H) only when a delay difference occurring at two inputters exceeds a threshold. In addition, the XOR element may also be designed such that the threshold may be variably adjusted.

Although FIG. 7A illustrates the example of reading using a delay difference, examples are not limited thereto. A memory device may output a result of sensing a voltage difference by supplying power to resistive memory elements. The memory device may output a result of sensing a current difference by applying a voltage to the resistive memory elements. The memory device may be implemented in various structures that may compare resistance values set for two adjacent resistive memory elements.

In operation 637, the memory device may read an output of a latch circuit through a clock synchronized with an edge. For example, the memory device may read a bit value set for the Node Q of the SR latch through a clock synchronized with the rising edge and the falling edge of the strobe signal STRB through an input/output (I/O) logic. As described above, bit values for resistive memory cells positioned in the same word line 720 may be read altogether.

When an output of bit-read signals is completed, the memory device may return to operation 631 and may wait for a next memory access request in an idle state.

Although FIG. 7A mainly illustrates XOR encoding; examples are not limited thereto. The memory device may have resistance values set based on XNOR encoding instead of XOR encoding. FIG. 7B illustrates an operation of reading a resistance value on which XNOR encoding has been performed, and FIG. 9 illustrates the XNOR encoding.

The memory device, according to an embodiment, may read a bit sequence from resistance values set based on the XNOR encoding. For example, unlike the first and second readout units 751 and 752 of FIG. 7A which include an XOR element, a readout circuit 250b illustrated in FIG. 7B may include readout units 751b and 752b having an XNOR element. In the readout circuit 250b, an output waveform of the XNOR element and an output waveform QB of an SR latch may be a waveform inverted from an output waveform of the XOR element and an output waveform Q of the SR latch. Other operations of the readout circuit 250b may be similar to the operation of the readout circuit 250 described above with reference to FIG. 7A. Operations 631, 632, 633, 634, and 635 are the same as they are in FIG. 7A, and thus, repeated description is omitted. For all intents and purposes, description of XOR operations are conceptually applicable to XNOR operations

In operation 636, the memory device may set a latch circuit using an XNOR operation result according to a delay difference. According to an embodiment, the readout circuit 250b may include an XNOR element connected to two adjacent resistive memory cells among N+1 resistive memory cells. FIG. 7B illustrates an example that a first readout unit 751b and a second readout unit 752b individually include an XNOR element. For example, the first readout unit 751b may output 1 when the resistance value of the first resistive memory element A and the resistance value of the second resistive memory element B are the same and may output 0 when different.

In the example illustrated in FIG. 7B, a voltage may be provided to an inputter of an XNOR element by power driven to the bit line. The time during which the voltage is charged or discharged may vary depending on a parasitic capacitance formed along the bit line and a resistance value set for a resistive memory cell. The XNOR element may output a comparison result (e.g., 1 when two resistive memory elements are the same, and 0 when different) of resistance values set for two resistive memory elements through a delay (e.g., a charge delay or a discharge delay) varying depending on a resistance value set for each resistive memory element. For example, each XNOR circuit of the readout circuit 250b may output an XNOR output as "0" when a delay difference exceeds a threshold and may output the XNOR output as "1" when the delay difference is less than or equal to the threshold.

For example, among the word lines, when the resistance values stored in the first resistive memory element A and the second resistive memory element B of the first address A0 are R_{P} and R_{AP}, the XNOR element may generate an output pulse corresponding to "0" (or the logic value L) during the delay difference t_{AP}-t_{P}. This output pulse may be transmitted to a set port of an SR latch in a corresponding readout unit. An output waveform QB of the SR latch may output a signal corresponding to "0" (or the logic value L). For reference, although FIG. 7A illustrates the NOR gate-based SR latch operating active-high, FIG. 7B illustrates a NAND gate-based SR latch operating active-low. The output pulse generated in the XNOR element may be input to a node SN of the SR latch, and the SR latch of FIG. 7B may generate an output in a node QB.

For another example, among the word lines, when the resistance values stored in the first resistive memory element A and the second resistive memory element B of the second address A1 are R_{AP} and R_{P}, the XNOR element may generate the output pulse corresponding to the logic value L during the delay difference t_{AP}-t_{P}. The node QB of the SR latch may output the signal corresponding to "0" (or the logic value L).

In yet another example, when the resistance values stored in the first resistive memory element A and the second resistive memory element B of the third address A2 are R_{P} and R_{P}, the XNOR element may provide a signal corresponding to "1" (or the logic value H). Accordingly, the SR latch may maintain a value of 1 (e.g., the signal corresponding to the logic value H) initialized through a reset signal (RN of FIG. 7B) at the node QB. Since the delay is the same as t_{AP} in a fourth address A3, a QB output of the SR latch may be maintained at 1.

In operation 637, the memory device may read an output of a latch circuit through a clock synchronized with an edge. For example, the memory device may read a bit value set for the node QB of the SR latch through a clock synchronized with the rising edge and the falling edge of the strobe signal STRB through the I/O logic.

FIGS. 8, 9A, and 9B illustrate a write operation through a write circuit in the memory device, according to one or more embodiments.

In operation 811, the memory device may wait for a memory access request in an idle state. The memory device may initiate an operation for memory writing in response to receiving a memory write request.

In operation 813, the memory device may perform XOR encoding on data. According to an embodiment, the memory device may perform XOR encoding on an N-bit bit sequence included in the data of the memory write request through the write encoder 273. For example, the write encoder 273 may include XOR elements. An XOR element may be implemented as an XOR gate, for example. The XOR gate may output 0 when the inputs are the same and may output 1 when the inputs are different, according to the truth table described in Table 1 above.

Referring to FIG. 9A, in the write encoder 273, an output of at least one XOR element of the plurality of XOR elements may be connected to one of the inputs of another XOR element. For example, outputs of remaining XOR elements, except for an XOR element 939 corresponding to a least significant bit (LSB), among the plurality of XOR elements, the outputs may be respectively connected to inputs of different (next/adjacent) XOR elements. The write encoder 273 may generate N+1 write signals including outputs of the plurality of XOR elements and a reference signal REF. Referring to FIG. 9A, a total of nine write signals XOR[7:0] and the reference signal REF may be generated, in which N=8. The memory device may convert bit sequences DATA[7:0] into the write signals XOR[7:0].

The write encoder 273 may include a first XOR element 931 and a second XOR element 932 to a last XOR element 939 corresponding to the LSB. The first XOR element 931 may receive a bit signal DATA[7] corresponding to an MSB and the reference signal REF and may generate a first XOR result between a bit value of the MSB and a bit value of the reference signal REF. The second XOR element 932 may receive a subsequent bit signal DATA[6] of the MSB and the first XOR result and may generate a second XOR result between a bit value of the subsequent bit signal and the first XOR result. The write encoder 273 may generate write signals corresponding to an XOR encoding result by providing an output of an XOR element together with a bit value of a subsequent bit as an input of a subsequent XOR element. Each of the write signals output from the XOR elements of the write encoder 273 may indicate a value according to a corresponding XOR result.

According to an embodiment, as described above with reference to FIG. 5, the same bit sequence may be expressed by two resistance value combinations. For example, depending on whether the corresponding reference signal REF is 1 or 0, the other resistance value combinations may vary accordingly. Each of the resistance value combinations may be a value inverted from the other resistance value combinations. The memory device may select any one combination of two available resistance value combinations for the same bit sequence. For example, available resistance value combinations for data (e.g., the bit sequences DATA[7:0]) of 8'b10010101 may be expressed by Table 6 below.

**Table 6**

| REF | COL_REF | DATA[7:0] | XOR[7:0] | (COL[7], COL[6], COL[5], COL[4], COL[3], COL[2], COL[1]) |
|---|---|---|---|---|
| 0 | R_{P} | 10010101 | 11100110 | (R_{AP}, R_{AP}, R_{AP}, R_{P}, R_{P}, R_{AP}, R_{AP}, R_{P}) |
| 1 | R_{AP} | 10010101 | 00011001 | (R_{P}, R_{P}, R_{P}, R_{AP}, R_{AP}, R_{P}, R_{P}, R_{AP}) |

According to an embodiment, the memory device may select a resistance value combination, of which a predicted power consumption for writing is low, from among the available resistance value combinations. For example, a control circuit (not shown) of the memory device may predict a power consumption for each of the available resistance value combinations for a corresponding word line. For example, the control circuit may count the resistance change number (e.g., resistance flip number) required to write each resistance value combination in a corresponding word line. The control circuit may count the number of required resistance changes from an LRS to an HRS and the number of required resistance changes from the HRS to the LRS. The control circuit may calculate the number of required resistance changes and a total power consumption estimate based on the power consumption required in a corresponding resistance change. In addition, the memory device may select a resistance value combination, of which the total number of resistance changes required for the N+1 resistive memory cells is small, from among the available resistance value combinations, based on the resistance values set for the N+1 resistive memory cells of a word line 901 selected for writing.

The control circuit may select any one of the available resistance value combinations considering a power consumption for reading. For example, a current may be supplied to each resistive memory element for reading and a bit value may be read based on a voltage. In this case, a read power consumption of a resistance value combination in which the number of resistive memory elements in the LRS in the same word line is greater than the number of resistive memory elements may be less than a read power consumption of a resistance value combination in the opposite way. Accordingly, the control circuit may select a combination in which a ratio of the LRS is high from among the available resistance value combinations.

The control circuit may provide the reference signal REF having a value determined according to the selected resistance value combination. As described above, the write encoder 273 may generate write signals by providing bit signals and the reference signal REF to XOR elements connected in series.

In operation 815, the memory device may activate a word line corresponding to a memory write request. The memory device may activate a word line based on the decoding of an address of a write request.

In operation 817, the memory device may record encoded data in the activated word line. For example, the write driver 275 may receive the write signals XOR[7:0] from the write encoder 273. The write driver 275 may set resistance value combinations COL[7:0] corresponding to the write signals XOR[7:0] for resistive memory cells of the selected word line 901. The reference write signal 271 may set a resistance value COL_REF corresponding to the reference signal REF for a resistive memory cell positioned in a reference column line. The memory device may change a resistance value of a resistive memory cell including a different resistance value from the resistance value combination selected from among the N+1 resistive memory cells of the word line 901 selected for writing. In addition, the memory device may maintain a resistance value of a resistive memory cell including the same resistance value as the resistance value combination selected from among the N+1 resistive memory cells of the word line 901 selected for writing. In this case, the memory device may skip writing of a resistance value for a resistive memory cell of which a resistance value before change is the same as a resistance value after the change.

Since the structure of the write encoder 273 is simple, the area, power consumption, and latency overhead for a write operation may be little. In addition, the write encoder 273 may rapidly operate at a supply voltage of a general logic level.

Although FIG. 9A illustrates XOR encoding, examples are not limited thereto. As illustrated in FIG. 9B, the memory device may perform XNOR encoding.

According to an embodiment, the memory device may set resistance values corresponding to a bit sequence according to a result of performing XNOR encoding. For example, unlike the write encoder 273 includes the XOR elements 931 and 932 to 939 in FIG. 9A, the write encoder 273b illustrated in FIG. 9B may include XNOR elements 931b and 932b to 939b. Only the type of elements may differ, and a connection relationship between the elements may be the same as that of FIGS. 9A and 9B. An operation of a write driver 275b may be similar to the operation of the write driver 275 of FIG. 9A. Operations 811 and 815 are the same as they are in FIG. 9A, and thus, repeated description is omitted.

In operation 813, the memory device may perform XNOR encoding on data. According to an embodiment, the memory device may perform XNOR encoding on an N-bit bit sequence included in the data of the memory write request through the write encoder 273b of FIG. 9B. For example, the write encoder 273b may include a plurality of XNOR elements. An XNOR element may be implemented as an XNOR gate, for example. The XNOR gate may output 1 when the inputs are the same and may output 0 when the inputs are different.

Referring to FIG. 9B, in the write encoder 273b, an output of at least one XNOR element of the plurality of XNOR elements may be connected to an input of another XNOR element. For example, outputs of remaining XNOR elements, except for the XNOR element 939b corresponding to an LSB, among the plurality of XNOR elements, may be respectively connected to inputs of different XNOR elements. The write encoder 273b may generate N+1 write signals including outputs of the plurality of XNOR elements and the reference signal REF. Referring to FIG. 9B, a total of nine write signals XNOR[7:0] and the reference signal REF may be generated, in which N=8. The memory device may convert the bit sequences DATA[7:0] into the write signals XNOR[7:0].

The write encoder 273b may include a first XNOR element 931b and a second XNOR element 932b to a last XNOR element 939b corresponding to the LSB. The first XNOR element 931b may receive a bit signal DATA[7] corresponding to an MSB and the reference signal REF and may generate a first XNOR result between a bit value of the MSB and a bit value of the reference signal REF. The second XNOR element 932b may receive a subsequent bit signal DATA[6] of the MSB and the first XNOR result and may generate a second XNOR result between a bit value of the subsequent bit signal and the first XNOR result. The write encoder 273b may generate write signals corresponding to an XNOR encoding result by providing an output of an XNOR element together with a bit value of a subsequent bit as an input of a subsequent XNOR element. Each of the write signals output from the plurality of XNOR elements of the write encoder 273b may indicate a value according to a corresponding XNOR result.

In operation 817, the write driver 275b may receive the write signals XNOR[7:0] from the write encoder 273b. The write driver 275b may set a resistance value according to the received write signals XNOR[7:0].

The examples described herein may be implemented by using a hardware component, a software component, and/or a combination thereof. A processing device may be implemented using one or more general-purpose or special-purpose computers, such as, for example, a processor, a controller and an arithmetic logic unit (ALU), a digital signal processor (DSP), a microcomputer, a field-programmable gate array (FPGA), a programmable logic unit (PLU), a microprocessor, or any other device capable of responding to and executing instructions in a defined manner. The processing device may run an operating system (OS) and one or more software applications that run on the OS. The processing unit also may access, store, manipulate, process, and generate data in response to execution of the software. For purpose of simplicity, the description of a processing unit is used as singular; however, one skilled in the art will appreciate that a processing unit may include multiple processing elements and multiple types of processing elements. For example, the processing unit may include a plurality of processors, or a single processor and a single controller. In addition, different processing configurations are possible, such as parallel processors.

The software may include a computer program, a piece of code, an instruction, or some combination thereof, to independently or collectively instruct or configure the processing unit to operate as desired. Software and data may be stored in any type of machine, component, physical or virtual equipment, or computer storage medium or device capable of providing instructions or data to or being interpreted by the processing unit. The software also may be distributed over network-coupled computer systems so that the software is stored and executed in a distributed fashion. The software and data may be stored by one or more non-transitory computer-readable recording mediums.

The methods according to the above-described examples may be recorded in non-transitory computer-readable media including program instructions to implement various operations of the above-described examples. The media may also include, alone or in combination with the program instructions, data files, data structures, and the like. The program instructions recorded on the media may be those specially designed and constructed for the purposes of examples, or they may be of the kind well-known and available to those having skill in the computer software arts. Examples of non-transitory computer-readable media include magnetic media such as hard disks, floppy disks, and magnetic tape; optical media such as CD-ROM discs and DVDs; magneto-optical media such as optical discs; and hardware devices that are specially configured to store and perform program instructions, such as read-only memory (ROM), RAM, flash memory, and the like. Examples of program instructions include both machine code, such as produced by a compiler, and files containing higher-level code that may be executed by the computer using an interpreter.

The above-described devices may act as one or more software modules in order to perform the operations of the above-described examples, or vice versa.

As described above, although the examples have been described with reference to the limited drawings, a person skilled in the art may apply various technical modifications and variations based thereon. For example, suitable results may be achieved if the described techniques are performed in a different order and/or if components in a described system, architecture, device, or circuit are combined in a different manner and/or replaced or supplemented by other components.

Therefore, other implementations and other examples are also within the scope of the following claims.

The computing apparatuses, the vehicles, the electronic devices, the processors, the memories, the image sensors, the vehicle/operation function hardware, the ADAS/AD systems, the displays, the information output system and hardware, the storage devices, and other apparatuses, devices, units, modules, and components described herein with respect to FIGS. 1-11 are implemented by or representative of hardware components. Examples of hardware components that may be used to perform the operations described in this application where appropriate include controllers, sensors, generators, drivers, memories, comparators, arithmetic logic units, adders, subtractors, multipliers, dividers, integrators, and any other electronic components configured to perform the operations described in this application. In other examples, one or more of the hardware components that perform the operations described in this application are implemented by computing hardware, for example, by one or more processors or computers. A processor or computer may be implemented by one or more processing elements, such as an array of logic gates, a controller and an arithmetic logic unit, a digital signal processor, a microcomputer, a programmable logic controller, a field-programmable gate array, a programmable logic array, a microprocessor, or any other device or combination of devices that is configured to respond to and execute instructions in a defined manner to achieve a desired result. In one example, a processor or computer includes, or is connected to, one or more memories storing instructions or software that are executed by the processor or computer. Hardware components implemented by a processor or computer may execute instructions or software, such as an operating system (OS) and one or more software applications that run on the OS, to perform the operations described in this application. The hardware components may also access, manipulate, process, create, and store data in response to execution of the instructions or software. For simplicity, the singular term "processor" or "computer" may be used in the description of the examples described in this application, but in other examples multiple processors or computers may be used, or a processor or computer may include multiple processing elements, or multiple types of processing elements, or both. For example, a single hardware component or two or more hardware components may be implemented by a single processor, or two or more processors, or a processor and a controller. One or more hardware components may be implemented by one or more processors, or a processor and a controller, and one or more other hardware components may be implemented by one or more other processors, or another processor and another controller. One or more processors, or a processor and a controller, may implement a single hardware component, or two or more hardware components. A hardware component may have any one or more of different processing configurations, examples of which include a single processor, independent processors, parallel processors, single-instruction single-data (SISD) multiprocessing, single-instruction multiple-data (SIMD) multiprocessing, multiple-instruction single-data (MISD) multiprocessing, and multiple-instruction multiple-data (MIMD) multiprocessing.

The methods illustrated in FIGS. 1-11 that perform the operations described in this application are performed by computing hardware, for example, by one or more processors or computers, implemented as described above implementing instructions or software to perform the operations described in this application that are performed by the methods. For example, a single operation or two or more operations may be performed by a single processor, or two or more processors, or a processor and a controller. One or more operations may be performed by one or more processors, or a processor and a controller, and one or more other operations may be performed by one or more other processors, or another processor and another controller. One or more processors, or a processor and a controller, may perform a single operation, or two or more operations.

Instructions or software to control computing hardware, for example, one or more processors or computers, to implement the hardware components and perform the methods as described above may be written as computer programs, code segments, instructions or any combination thereof, for individually or collectively instructing or configuring the one or more processors or computers to operate as a machine or special-purpose computer to perform the operations that are performed by the hardware components and the methods as described above. In one example, the instructions or software include machine code that is directly executed by the one or more processors or computers, such as machine code produced by a compiler. In another example, the instructions or software includes higher-level code that is executed by the one or more processors or computer using an interpreter. The instructions or software may be written using any programming language based on the block diagrams and the flow charts illustrated in the drawings and the corresponding descriptions herein, which disclose algorithms for performing the operations that are performed by the hardware components and the methods as described above.

The instructions or software to control computing hardware, for example, one or more processors or computers, to implement the hardware components and perform the methods as described above, and any associated data, data files, and data structures, may be recorded, stored, or fixed in or on one or more non-transitory computer-readable storage media. Examples of a non-transitory computer-readable storage medium include read-only memory (ROM), random-access programmable read only memory (PROM), electrically erasable programmable read-only memory (EEPROM), random-access memory (RAM), dynamic random access memory (DRAM), static random access memory (SRAM), flash memory, non-volatile memory, CD-ROMs, CD-Rs, CD+Rs, CD-RWs, CD+RWs, DVD-ROMs, DVD- Rs, DVD+Rs, DVD-RWs, DVD+RWs, DVD-RAMs, BD-ROMs, BD-Rs, BD-R LTHs, BD-REs, blue-ray or optical disk storage, hard disk drive (HDD), solid state drive (SSD), flash memory, a card type memory such as multimedia card micro or a card (for example, secure digital (SD) or extreme digital (XD)), magnetic tapes, floppy disks, magneto-optical data storage devices, optical data storage devices, hard disks, solid-state disks, and any other device that is configured to store the instructions or software and any associated data, data files, and data structures in a non-transitory manner and provide the instructions or software and any associated data, data files, and data structures to one or more processors or computers so that the one or more processors or computers can execute the instructions. In one example, the instructions or software and any associated data, data files, and data structures are distributed over network-coupled computer systems so that the instructions and software and any associated data, data files, and data structures are stored, accessed, and executed in a distributed fashion by the one or more processors or computers.

While this disclosure includes specific examples, it will be apparent after an understanding of the disclosure of this application that various changes in form and details may be made in these examples without departing from the scope of the claims. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components.

Therefore, in addition to the above disclosure, the scope of the invention is defined by the claims.

## Claims

1. A non-volatile memory device, the memory device comprising:
a memory array comprising N+1 resistive memory cells expressing a bit sequence of N bits for each word line, wherein
N is an integer greater than or equal to 2.

2. The memory device of claim 1, wherein,
when a bit value of a bit position in the bit sequence is a first bit value, resistance values of adjacent memory elements corresponding to the bit position among the N+1 resistive memory cells are the same, and,
when the bit value of the bit position is a second bit value, the resistance values of adjacent memory elements corresponding to the bit position among the N+1 resistive memory cells are different.

3. The memory device of claim 1 or 2, further comprising:
a write encoder configured to generate N+1 write signals individually indicating resistance values to be set for the N+1 resistive memory cells, based on a reference signal and N bit signals individually indicating bit values of the bit sequence.

4. The memory device of claim 3,
wherein the write encoder comprises a plurality of exclusive-OR, XOR, elements, and an output of at least one XOR element of the plurality of XOR elements is connected to an input of another XOR element, or
wherein the write encoder is configured to generate the N+1 write signals comprising outputs of a plurality of XOR elements and the reference signal, or
wherein the write encoder comprises a first XOR element configured to receive a bit signal corresponding to a most significant bit, MSB, and the reference signal and generate a first XOR result between a bit value of the MSB and a bit value of the reference signal, and a second XOR element configured to receive a subsequent bit signal of the MSB and the first XOR result and generate a second XOR result between a bit value of the subsequent bit signal and the first XOR result.

5. The memory device of one of claims 1 to 4, wherein resistance values according to a result of encoding the bit sequence based on XOR are set for resistive memory cells arranged along a word line selected for writing.

6. The memory device of one of claims 1 to 5, wherein the memory device is configured to set one resistance value combination among available resistance value combinations expressing the bit sequence for the N+1 resistive memory cells of a word line selected for writing.

7. The memory device of claim 6, wherein the memory device is configured to perform one or more of:
selecting a resistance value combination, of which a predicted power consumption for writing is low, from among the available resistance value combinations,
selecting a resistance value combination, of which the number of resistance changes required for the N+1 resistive memory cells is small, from among the available resistance value combinations, based on the resistance values set for the N+1 resistive memory cells of the word line selected for writing, and
changing a resistance value of a resistive memory cell comprising a different resistance value from the resistance value combination selected from among the N+1 resistive memory cells of the word line selected for writing, and maintaining a resistance value of a resistive memory cell comprising the same resistance value as the resistance value combination selected from among the N+1 resistive memory cells of the word line selected for writing.

8. The memory device of one of claims 1 to 7, further comprising:
a readout circuit configured to generate bit read signals based on XOR results for resistance values set for the N+1 resistive memory cells arranged along a word line selected for reading.

9. The memory device of claim 8, wherein the readout circuit comprises an XOR element connected to two adjacent resistive memory cells among the N+1 resistive memory cells, or
wherein the readout circuit is configured to output, as a bit value for the two adjacent resistive memory cells, a comparison result between delays occurring in the two adjacent resistive memory cells, according to a parasitic capacitance and resistance values set for the two adjacent resistive memory cells.

10. The memory device of claim 1, arranged for:
setting resistance values expressing a bit sequence of N bits for N+1 resistive memory cells arranged in a word line selected for writing in the memory array, and outputting N bit read signals from N+1 resistive memory cells arranged in a word line selected for reading in the memory array.

11. The memory device of claim 10 further comprising a write encoder and a write driver, wherein
the write encoder is arranged for generating N+1 write signals individually indicating resistance values to be set for the N+1 resistive memory cells, based on a reference signal and N bit signals individually indicating bit values of the bit sequence, and
the write driver is arranged for setting resistance values of the N+1 resistance memory cells by using the N+1 write signals.

12. A method of encoding a bit value by using two resistive memory cells that are adjacent to each other, the memory encoding method comprising:
when the bit value is a first value, setting the same resistance value for the two resistive memory cells; and,
when the bit value is a second value that is different from the first value, setting different resistance values for the two resistive memory cells.

13. The memory encoding method of claim 12, wherein
the encoding is an exclusive OR, XOR, wherein the first value is 0 and the second value is 1, or
the encoding is an exclusive negative OR, XNOR, wherein the first value is 1 and the second value is 0.

14. The memory encoding method of claim 12 or 13, further comprising encoding N bit values by using N+1 resistive memory cells.

15. The memory encoding method of claim 14, wherein the N+1 resistive memory cells are connected to a shared word line, wherein
N is an integer greater than or equal to 2.
